# FASCICULE DE BREVET EUROPEEN

(11) **EP 3 271 961 B1**
(45) Date de publication et mention de la délivrance du brevet: **12.12.2018**
(21) Numéro de dépôt: 16710192.2
(22) Date de dépôt: 16.03.2016
(51) Int. Cl.: H01M 8/04298, H01M 8/04537, G01R 31/36

(54) **CELLULE DE TEST D'APPAREILLAGE DE CARACTÉRISATION DE CELLULE DE PILE À COMBUSTIBLE ET PROCÉDÉ DE FABRICATION D'UNE TELLE CELLULE DE TEST**
PRÜFZELLE EINER VORRICHTUNG ZUR CHARAKTERISIERUNG EINER ZELLE EINER BRENNSTOFFZELLE UND VERFAHREN ZUR HERSTELLUNG SOLCH EINER PRÜFZELLE
TEST CELL OF AN APPARATUS FOR CHARACTERISING A CELL OF A FUEL CELL AND METHOD FOR PRODUCING SUCH A TEST CELL

(30) Priorité: 18.03.2015 FR 1552225
(43) Date de publication de la demande: 24.01.2018
(73) Titulaire: Commissariat à l'Énergie Atomique et aux Énergies Alternatives, 75015 Paris (FR)
(72) Inventeur: VULLIET, Julien, 37300 Joué-lès-Tours (FR)
(74) Mandataire: Brevalex
(86) Numéro de dépôt international: PCT/EP2016/055708
(87) Numéro de publication internationale: WO 2016/146696

(56) Documents cités:
- US-B2- 8 125 193
- "Universal Dummy Cell 4 - Operator's Manual", , 28 février 2011 (2011-02-28), XP055193529, Extrait de l'Internet: URL:http://www.gamry.com/assets/Support-Do wnloads/Product-Manuals/UDC4 - Universal Dummy Cell 4 Operators Manual.pdf [extrait le 2015-06-03]
- "SI1287 Electrochemical Interface USER GUIDE (extract from)", , 1 juin 1999 (1999-06-01), XP055193728, Extrait de l'Internet: URL:http://www.chemistry.hku.hk/staff/kyc/ equipment/1287_manual.pdf [extrait le 2015-06-04]
- "Impedance Spectroscopy Theory, Experiment, and Applications (extract from)", , 1 janvier 2005 (2005-01-01), pages 184-185, XP055193701, Extrait de l'Internet: URL:http://cdn.preterhuman.net/texts/scien ce_and_technology/physics/spectroscopy/Imp edance%20Spectroscopy,%20Theory%20Experime nt%20and%20Applications%20-%20Macdonald.pd f [extrait le 2015-06-04]
- WOOJIN CHOI ET AL: "Development of an equivalent circuit model of a fuel cell to evaluate the effects of inverter ripple current", 2004 IEEE APPLIED POWER ELECTRONICS CONFERENCE AND EXPOSITION, APEC 04, IEEE, ANAHEIM, CA, USA, vol. 1, 22 février 2004 (2004-02-22), pages 355-361, XP010704081, DOI: 10.1109/APEC.2004.1295834 ISBN: 978-0-7803-8269-5
- REGGIANI ET AL: "Modelling a PEM fuel cell stack with a nonlinear equivalent circuit", JOURNAL OF POWER SOURCES, ELSEVIER SA, CH, vol. 165, no. 1, 16 janvier 2007 (2007-01-16), pages 224-231, XP005883220, ISSN: 0378-7753, DOI: 10.1016/J.JPOWSOUR.2006.11.062
- RUNTZ K J ET AL: "Fuel cell equivalent circuit models for passive mode testing and dynamic mode design", ELECTRICAL AND COMPUTER ENGINEERING, 2005. CANADIAN CONFERENCE ON SASKATOON, SK, CANADA MAY 1-4, 2005, PISCATAWAY, NJ, USA,IEEE, PISCATAWAY, NJ, USA, 1 mai 2005 (2005-05-01), pages 794-797, XP010868926, DOI: 10.1109/CCECE.2005.1557048 ISBN: 978-0-7803-8885-7

## Description

### DOMAINE TECHNIQUE

L'invention se rapporte au domaine des piles à combustible et des cellules constituant de telles piles et concerne plus particulièrement la qualification et/ou l'étalonnage des appareillages permettant la caractérisation de ces piles à combustible et de leurs cellules.

### ÉTAT DE LA TECHNIQUE ANTÉRIEURE

Les recherches actuellement menées sur les énergies renouvelables et les énergies alternatives aux combustibles fossiles ont permis la mise en lumière des piles à combustible et notamment à hydrogène. Ces piles à combustible sont en effet l'une des seules alternatives viables aux énergies fossiles pour le transport sur les longues distances pour lesquelles les batteries montrent leurs limites.

Le développement de ces piles à combustible fait appel à des appareillages de caractérisation spécifiques, tels que des analyseurs de fréquence, des potentiostats et des galvanostats. Ces appareillages, et leurs systèmes de connexion, doivent être adaptés aux particularités des piles à combustibles et aux cellules qui les constituent. En effet, les cellules de piles à combustible, et les piles les comportant, présentent la particularité de présenter une impédance variable et fortement dépendante des conditions de mesure. Ainsi la bande passante de la connectique employée et l'existence d'éventuels couplages parasites sont ainsi notamment critiques. En particulier, en raison des températures de fonctionnement de certaines piles à combustible, les câbles employés ne peuvent être blindés et ce sont donc des fils de platine qui sont employés pour faire la connexion de la cellule ou pile à caractériser avec les appareillages de caractérisation. Une telle absence de blindage rend évidemment ces appareillages sujets à une forte problématique de parasitage.

Pour ces raisons, et pour s'assurer de la justesse des futures caractérisations, lors de l'installation, et tout au long de leur fonctionnement, ces appareillages doivent être qualifiés et étalonnés soit, selon une première possibilité, avec des boîtiers tests tels que le module de test 12861 fourni par Solartron (voir par exemple le document "SI1287 Electrochemical Interface USER GUIDE", 1 juin 1999, XP055193728) ou le module de test UDC4™ fourni par Gamry Instruments (voir par exemple le document "Universal Dummy Cell 4 - Operator's Manual", 28 février 2011, XP055193529, URL : http://www.gamry.com/assets/Support-Downloads/Product-Manuals/UDC4 - Universal Dummy Cell 4 Operators Manual.pdf), soit, selon une deuxième possibilité, avec des cellules dites « sacrificielles ».

Concernant la première possibilité, les boîtiers test ne permettent pas de « réellement » qualifier les appareillages de caractérisation et en particulier leurs systèmes de connexion. En effet, les conditions d'utilisation de tels boîtiers sont très éloignées des conditions réelles de caractérisation d'une cellule et/ou d'une pile à combustible. Le boîtier est en effet directement connecté à l'appareillage de caractérisation au moyen de connecteurs classiques, tels que des câblages coaxiaux. Ainsi, même en mettant de côté le fait que ces boîtiers ne sont généralement pas appropriés pour être réellement représentatifs d'une cellule et/ou d'une pile à combustible, ils ne permettent pas de tenir compte des problématiques de connexion des cellules et/ou piles à combustible. Un étalonnage avec de tels boîtiers est ainsi réalisé sans prise en compte des câbles employés pour faire la jonction entre la cellule ou pile à caractériser et les appareillages de caractérisation et le contact entre ces câbles et la cellule ou la pile à combustible. Or ces câbles et le contact entre eux et la cellule ou pile peuvent engendrer des artefacts de mesure ou des dérives dans le temps de la mesure qu'il est nécessaire de pouvoir corriger.

La deuxième possibilité, si elle permet une caractérisation aux plus proches des conditions réelles d'utilisation de l'appareillage à étalonner, est bien entendu plus coûteuse à mettre en oeuvre. Cette deuxième possibilité fait de plus intervenir des conditions de température qui rendent particulièrement compliquée la qualification des appareillages de caractérisation. Cette solution n'est donc pas non plus des plus appropriée.

### EXPOSÉ DE L'INVENTION

L'invention vise à résoudre au moins partiellement les inconvénients mentionnés ci-dessus et a ainsi pour but de fournir un dispositif permettant la qualification et/ou l'étalonnage d'appareil de caractérisation de cellules et/ou de piles à combustible en prenant en compte des problématiques de connexion des cellules et/ou pile à combustible, ceci sans avoir à utiliser une cellule ou une pile à combustible sacrificielle.

L'invention concerne à cet effet une cellule de test destinée à la qualification d'appareillage de caractérisation électrique de cellules de piles à combustible et/ou de piles à combustible. Ladite cellule de test comporte :
- une première et une deuxième face de contact comportant respectivement une première et une deuxième couche métallique occupant tout ou partie de la surface de la face contact correspondant et formant respectivement une première et une deuxième zone de contact, la première et la deuxième face de contact délimitant entre elles un volume intérieur,
- un circuit équivalent passif configuré pour présenter une impédance équivalente à au moins une cellule de pile à combustible, ledit circuit équivalent comportant une première et une deuxième borne de sortie connectées respectivement à la première et la deuxième zone de contact, le circuit équivalent passif étant logé dans le volume intérieur.

Une telle cellule permet une prise de contact au plus proche de celle d'une cellule ou d'une pile à combustible. En effet, une telle cellule de test peut être connectée au moyen de ces deux faces de contact avec une configuration similaire à celle d'une cellule ou d'une pile à combustible.

En effet, dans un banc de test de cellules électrochimiques de pile à combustible, la connexion électrique entre la ou les cellules de pile à combustible et les appareillages de caractérisation électrique est réalisée par des grilles métalliques (type platine, or, nickel, argent...) ou par des interconnecteurs massifs métalliques. Afin d'assurer un bon contact électrique, un serrage de l'ensemble est nécessaire.

Ainsi, la cellule test en présentant des couches métallique représentative de celle d'une ou plusieurs cellules de pile à combustible, il est possible de la connecter en utilisant les mêmes grilles métalliques ou les mêmes interconnecteurs massifs métalliques tout en appliquant la même force de serrage sur l'ensemble. La connexion d'une cellule teste selon l'invention est donc représentative de celle qui est obtenue avec une cellule à pile à combustible.

La connexion entre la cellule test et l'appareillage peut donc ainsi se faire avec les mêmes câbles et avec les même conditions de contact que ceux qui seront employés avec les cellules et/ou piles à combustible. De cette manière il est possible de qualifier et/ou étalonner un appareillage en prenant en compte les problématiques de connexion des cellules et des piles à combustible sans avoir à utiliser une cellule ou une pile à combustible sacrificielle.

De plus, avec un circuit équivalent adapté pour occuper un volume contenu, il est possible, en définissant convenablement les dimensions du volume intérieur, d'obtenir une cellule de test présentant les mêmes dimensions qu'une cellule de pile à combustible. Dans ces conditions, la cellule de test est parfaitement adaptée pour équiper un banc de caractérisation et être aisément substituée par une cellule à caractériser une fois l'appareillage convenablement étalonné.

On entend ci-dessus et dans le reste de ce document par « circuit équivalent passif » que le circuit présente une impédance équivalente à une cellule de pile à combustible de référence, c'est-à-dire comprise entre 90% et 110% de celle de cette même cellule de pile à combustible de référence sur au moins une plage de fréquences donnée, telle que par exemple entre 0,1 Hz et 100 MHz. On peut ainsi noter qu'une telle équivalence peut être, par exemple, vérifiée en traçant un diagramme de Nyquist sur la plage de résistance donnée. De tels circuits équivalents passifs sont connus de l'art antérieur, notamment du document US 8125193 B2 et de l'article de Cooper K. R. et Smith M. publié dans le journal scientifique « Journal of Power Sources » n° 160 pages 1088, 1095 en 2006.

On entend ci-dessus et dans le reste de ce document par volume intérieur limité par deux faces, le volume intérieur d'une enveloppe fermée composée desdites deux faces et d'une surface qui, reliant lesdites deux faces, présente une aire minimale. On peut noter dans le cas particulier qui peut classiquement être mis en oeuvre dans le cadre de l'invention où la première et la deuxième face sont sensiblement identiques et parallèles l'une à l'autre, la surface d'aire minimale est la surface délimitée par l'ensemble des segments de droite d'extrémités reliant deux à deux les points homologues respectifs de la périphérie de la première et de la deuxième face.

Le reste du volume intérieur peut être empli d'une résine durcissable telle qu'une résine époxyde, polyester insaturé ou époxy acrylate.

Une telle résine permet de fournir une cellule présentant à la fois une bonne tenue mécanique, similaire à celle des cellules de piles à combustible et des piles à combustible, et une bonne isolation électrique pour le circuit équivalent passif.

On entend ci-dessus et dans le reste de ce document par matériau thermodurcissable tout matériau classiquement obtenu par polymérisation et réticulation de monomères, d'oligomères et/ou de pré-polymères, en présence d'un agent de réticulation, également dénommé "durcisseur", notamment sous l'effet d'un rayonnement (pour les compositions durcissables), de la chaleur (pour les compositions thermodurcissables), ou encore de la pression. A l'issue de cette polymérisation, qui est par ailleurs irréversible, on obtient un matériau durci qui présente des propriétés mécaniques relativement stables et neutres d'un point de vue chimique.

Le circuit équivalent peut comporter en série au moins les composants suivants :
- une première inductance,
- une première résistance,
- un à plusieurs ensembles composés chacun d'une capacité et d'une résistance montées en parallèle.

La valeur de l'inductance peut être comprise entre 0 et 10 mH, la valeur de chacune des résistances pouvant être comprise entre 0 et 1 Ohm et la valeur de chacune des capacités pouvant être comprise entre 10 µF et 1 F.

Un tel circuit équivalent permet d'obtenir aisément une impédance équivalente à celle d'une cellule de pile à combustible de référence sur une plage de fréquence bien définie. En effet, le choix du nombre d'ensembles et des valeurs des capacités et inductances des composants de ces ensembles permet de fixer précisément la plage de fréquences sur laquelle le circuit équivalent présente l'impédance équivalente.
la cellule de test selon l'invention peut comporter des composants du type composant monté en surface pour former le circuit équivalent.

On obtient ainsi un circuit équivalent parfaitement apte à être contenu dans le volume réduit d'une pile à combustible.

La première et la deuxième zone de contact peuvent être formées d'une couche métallique dont le métal est sélectionné dans le groupe comporte l'or et le platine.

Chacune des zones de contact peut occuper respectivement et sensiblement la totalité de la surface de la face de contact correspondante.

De telles zones de contact permettent d'obtenir une prise de contact par l'appareillage sur la cellule test similaire à celle d'une cellule à pile à combustible. Il est ainsi possible de parfaitement prendre en compte les conditions de contact qui seront employés avec les cellules et/ou piles à combustible.

Le circuit équivalent peut être configuré pour présenter une impédance équivalente à plusieurs cellules de pile à combustible mises en série et formant ainsi une pile à combustible de test.

L'invention concerne en outre un procédé de fabrication d'une cellule test destinée à la qualification d'appareillage de caractérisation de cellules de pile à combustible et/ou de piles à combustible, comportant les étapes consistant à :
- fournir un circuit équivalent passif configuré pour présenter une impédance équivalente à au moins une cellule de pile à combustible, ledit circuit équivalent comportant une première et une deuxième borne de sortie,
- fournir une première et une deuxième face de contact comportant chacune une zone de contact et les agencer pour qu'elles délimitent entre elles un volume intérieur dans lequel est logé le circuit équivalent avec sa première et sa deuxième borne de sortie connectées respectivement à la première et à la deuxième zone de contact.

Un tel procédé de fabrication permet la fourniture d'une cellule test selon l'invention et d'obtenir les avantages qui y sont liés.

L'étape de fourniture de la première et de la deuxième face de contact peut comporter une sous-étape consistant à :
- encapsuler le circuit équivalent dans un bloc de résine durcissable telle qu'une résine époxyde, polyester insaturé ou époxy acrylate avec la première et la seconde borne du circuit équivalent faisant saillie dudit bloc de résine obtenu après durcissement de ladite résine sur une première et une deuxième face dudit bloc.

L'étape de fourniture de la première et de la deuxième face de contact peut comporter en outre les sous-étapes supplémentaires consistant à :
- polir la première et deuxième face du bloc de résine desquelles la première et la deuxième borne du circuit équivalent font saillie,
- déposer une première et deuxième couche métallique sur la première et la deuxième face du bloc de résine pour former respectivement la première et la deuxième zone de contact.

De telles sous étapes permettent d'obtenir une cellule de test selon l'invention présentant des caractéristiques mécaniques et/ou de prise de contact similaires à celles d'une cellule à pile à combustible ou d'une pile à combustible assurant ainsi une qualification de l'appareillage de caractérisation particulièrement adaptée.

### BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :
- les figures la à 1c illustrent schématiquement les principales étapes de fabrication d'une cellule de test selon l'invention,
- la figure 2 illustre schématiquement le circuit équivalent passif d'une cellule de pile à combustible utilisable dans une cellule test selon l'invention,
- les figures 3a et 3b illustrent chacune un diagramme de Nyquist obtenu avec respectivement un circuit équivalent selon l'invention et avec une cellule de pile à combustible.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

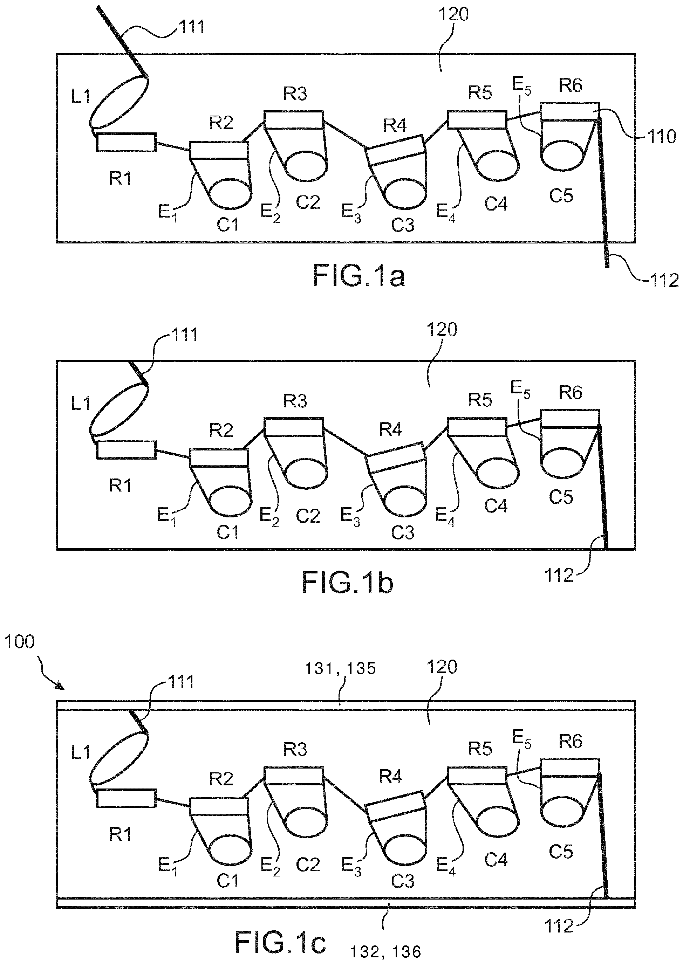

Les figures la à 1c illustrent les principales étapes de fabrication d'une cellule de test 100 selon l'invention. Une telle cellule de test 100, représentée sur la figure 1c, est adaptée pour permettre une qualification et/ou un étalonnage d'un appareillage de caractérisation de cellules et/ou de piles à combustible en étant placée en lieu et place de la cellule ou de la pile à combustible à caractériser.

Une telle cellule de test 100 comporte :
- une première et une deuxième face de contact 131, 132 comportant respectivement une première et une deuxième zone de contact métallique 135, 136 occupant la totalité de la surface de la face de contact 131, 132 correspondante, la première et la deuxième face de contact 131, 132 définissant entre elles un volume intérieur,
- un circuit équivalent 110 passif configuré pour présenter une impédance équivalente à celle d'une cellule de pile à combustible, ledit circuit équivalent 110 comportant une première et une deuxième borne de sortie 111, 112 connectés respectivement à la première et à la deuxième zone de contact 135, 136, le circuit équivalent étant logé dans le volume intérieur,
- un matériau de remplissage 120, tel qu'une résine thermodurcissable, emplissant le reste du volume intérieur laissé libre par le circuit équivalent 110, celui-ci matérialisant ainsi le volume intérieur.

La cellule de test 100 présente préférentiellement une forme générale conforme à celle des cellules à pile à combustible destinées à être caractérisées par le ou les appareils de caractérisation à qualifier et/ou étalonner. Ainsi, par exemple, la cellule de test 100 peut présenter une forme parallélépipédique carrée avec deux faces carrées de côté compris entre 1 et 25 cm et une hauteur entre ces deux faces comprise entre 0,5 et 5 cm. Dans une telle configuration, chacune des faces carrées forment l'une de la première et deuxième face de contact 131, 132. Ainsi, la première et la deuxième face de contact 131, 132 délimitent entre elles le volume du parallélépipède carré et donc le volume intérieur de la cellule de test 100.

Bien entendu, la cellule de test 100, comme des cellules de pile à combustible, peut présenter une forme générale autre, telle que par exemple celle d'un cylindre de révolution sans que l'on sorte du cadre de l'invention. Dans le cas où la cellule de test 100 présente une forme générale de cylindre de révolution, les bases du cylindre forment chacune l'une de la première et la deuxième face de contact 131, 132. Une telle cellule pourra présenter une première et deuxième face dont le diamètre est compris entre 1 et 20 cm pour une hauteur comprise entre 0,5 et 5 cm.

Un autre exemple de configuration envisageable est une forme parallélépipédique rectangle présentant deux faces rectangulaires de surface comprise entre 1 à 500 cm² séparée l'une de l'autre par une hauteur comprise entre 0,5 et 5 cm. Les deux faces rectangulaires forment respectivement la première et la deuxième face de contact 131, 132 et délimitent donc le volume intérieur, correspondant audit parallélépipède rectangle.

La première et la deuxième face de contact 131, 132, dans une configuration classique de l'invention, sont deux surfaces sensiblement identiques, planes, parallèles l'une à l'autre et se faisant face. La première et la deuxième zone de contact 135, 136 occupent respectivement tout ou partie de la surface de la face correspondante 131, 132. Dans la conformation illustrée sur la figure 1c, chacune des zones de contact 135, 136 occupe la totalité de la surface de la face de contact correspondant 131, 132.

La zone de contact 135, 136 est formée par une couche métallique déposée sur le matériau de remplissage 120. Une telle couche métallique peut être, par exemple une couche d'or ou de platine déposée par pulvérisation cathodique ou une laque conductrice dont a été enduit le matériau de remplissage 120. La zone de contact 135, 136 recouvre la totalité de la surface de la face de contact 131, 132 correspondante. Bien entendu, chaque zone de contact 135, 136 peut recouvrir qu'une seule portion de surface de la face de contact 131, 132 correspondante sans que l'on sorte du cadre de l'invention.

Le matériau de remplissage 120 permet d'assurer la rigidité de la cellule de test 100. Le matériau de remplissage peut être une résine thermodurcissable telle qu'une résine époxyde, polyester insaturé ou époxy acrylate.

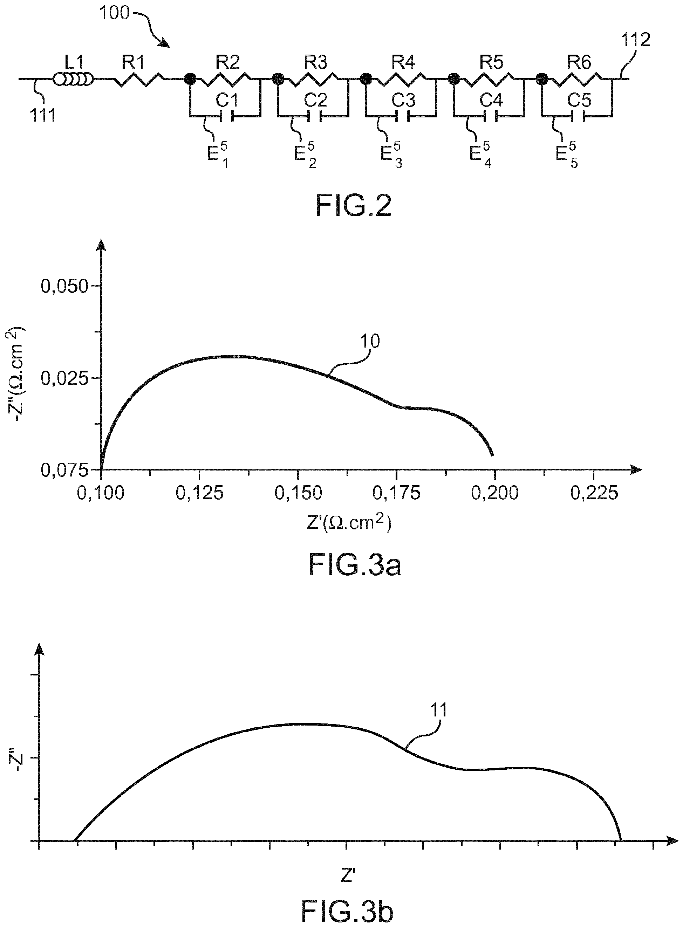

Le circuit équivalent passif peut comporter, comme illustré sur la figure 2, en série :
- une inductance L1,
- une première résistance R1,
- cinq ensembles E1, E2, E3, E4, E5 composés chacun d'une capacité C1 C2, C3, C4, C5 et d'une résistance R2, R3, R4, R5, R6 montées en parallèle.

L'inductance L1 est comprise entre 0 et 10 mH. Les résistances R1, R2, R3, R4, R5, R6 présentent des valeurs de résistance comprises entre 0 et 1 Ω. Les capacités présentent une valeur de capacité comprise entre 10 µF et 1 F.

La figure 3a illustre un exemple de diagramme de Nyquist qui peut être obtenu avec tel circuit équivalent. Pour cet exemple l'inductance a été fixée à 0,01 µH et la première résistance R1 à 0,1 Ω. Les valeurs de la deuxième résistance et des troisième et quatrième résistances ont été respectivement fixées à 0,05 Ω et 0,25 Ω, les résistances R5 et R6 étant nulles. Les valeurs de capacité retenues pour la première, deuxième et troisième capacité C1, C2, C3 sont respectivement 3 mF, 30 mF et 0,3 mF. Les quatrième et cinquième capacités C4, C5 sont, quant à elles, nulles.

On peut voir qu'avec de telles valeurs, le diagramme de Nyquist est équivalent à celui obtenu pour une cellule de pile à combustible classique représenté sur la figure 3b.

Pour permettre d'obtenir un circuit équivalent 110 occupant un volume contenu et ainsi permettre d'envisager l'invention afin de qualifier et/ou étalonner des appareillages de caractérisation dédiés pour des cellules de faibles dimensions, les composants du circuit équivalent passif peuvent être des composants du type à montage en surface, plus connus sous leur sigle CMS.

Une telle cellule de test 100 peut être fabriquée par un procédé de fabrication comportant les étapes suivantes de :
- fourniture du circuit équivalent 110 passif tel que celui schématisé sur la figure 2,
- encapsulation, comme illustré sur la figure la du circuit équivalent passif dans un matériau de remplissage, l'encapsulation étant réalisé de manière à ce que le matériau de remplissage présente après encapsulation le dimensionnement d'une cellule de pile à combustible et en ce que la première et la deuxième borne 111, 112 du circuit équivalent passif 110 fassent saillie du bloc de matériau de remplissage formé pendant l'encapsulation chacune sur une face de ce dernier,
- polissage, comme illustré sur la figure 1b, des faces du bloc de matériau de remplissage duquel font saillie la première et la deuxième borne ceci de manière à supprimer la partie saillante desdites première et deuxième bornes,
- formation, comme illustré sur la figure 1, sur lesdites face d'une première et deuxième zone de contact en contact respectif de la première et deuxième borne du circuit équivalent passif, la première et la deuxième face 131, 132 de la cellule étant ainsi formées.

Si dans le mode de réalisation décrit ci-dessus la cellule de test comporte un matériau de remplissage, il est bien entendu envisageable que la cellule ne comporte pas de matériau de remplissage. Selon cette possibilité, la première et la deuxième face de contact 131, 132, et les zone de contact 135, 136 correspondantes, peuvent être formées par une première et une deuxième plaque métallique liées rigidement l'une à l'autre, par exemple par une armature, et enfermant le circuit équivalent passif. Le circuit équivalant passif 110, afin d'assurer une installation pérenne dans le volume intérieur, peut être soudé sur un support du type circuit intégré supporté sur la surface intérieure de l'une de la première et deuxième plaque métallique.

Bien entendu, si dans le mode de réalisation décrit ci-dessus, le circuit équivalent passif comporte en série une inductance, une résistance et plusieurs ensembles résistance/capacité, il est également envisageable que la cellule test comporte un autre type de circuit équivalent, tels que par exemple ceux cités dans le document US 8125193 B2, sans que l'on sorte du cadre de l'invention.

## Revendications

1. Cellule de test (100) destinée à la qualification d'appareillage de caractérisation électrique de cellules de pile à combustible et/ou de piles à combustible, ladite cellule de test (100) étant **caractérisée en ce qu'**elle comporte :
- une première et une deuxième face de contact (131, 132) comportant respectivement une première et une deuxième couche métallique occupant tout ou partie de la surface de la face de contact (131, 132) correspondante et formant respectivement une première et une deuxième zone de contact (135, 136), la première et la deuxième face de contact (131, 132) délimitant entre elles un volume intérieur,
- un circuit équivalent (110) passif configuré pour présenter une impédance équivalente à au moins une cellule de pile à combustible, ledit circuit équivalent (110) comportant une première et une deuxième borne de sortie (111, 112) connectées respectivement à la première et la deuxième zone de contact (135, 136), le circuit équivalent (110) étant logé dans le volume intérieur.

2. Cellule de test (100) selon la revendication 1 dans laquelle le reste du volume intérieur est empli d'une résine durcissable telle qu'une résine époxyde, polyester insaturé ou époxy acrylate.

3. Cellule de test (100) selon la revendication 1 ou 2, dans laquelle le circuit équivalent (110) comporte en série au moins les composants suivants :
- une première inductance (L1),
- une première résistance (R1),
- un à plusieurs ensembles (E1, E2, E3, E4, E5) composés chacun d'une capacité (C1, C2, C3, C4, C5) et d'une résistance (R2, R3, R4, R5, R6) montées en parallèle.

4. Cellule de test (100) selon la revendication 3, dans laquelle la valeur de l'inductance de l'inductance (L1) est comprise entre 0 et 10 mH, la valeur de chacune des résistances (R1, R2, R3, R4, R5, R6) est comprise entre 0 et 1 Ohm et la valeur de chacune des capacités (C1, C2, C3, C4, C5) est comprise entre 10 µF et 1 F.

5. Cellule de test (100) selon l'une quelconque des revendications 1 à 4 comporte des composants (L1, R1, R2, R3, R4, R5, R6, C1, C2, C3, C4, C5) du type composant monté en surface pour former le circuit équivalent (110).

6. Cellule de test (100) selon l'une quelconque des revendications 1 à 5, dans laquelle la première et la deuxième zone de contact (135, 136) sont formées d'une couche métallique dont le métal est sélectionné dans le groupe comportant l'or et le platine.

7. Cellule de test (100) selon l'une quelconque des revendications 1 à 6, dans laquelle chacune des zones de contact (135, 136) occupe respectivement et sensiblement la totalité de la surface de la face de contact (131, 132) correspondante.

8. Cellule de test (100) selon l'une quelconque des revendications 1 à 7, dans laquelle le circuit équivalent (110) est configuré pour présenter une impédance équivalente à plusieurs cellules de pile à combustible mises en série et formant ainsi une pile à combustible de test.

9. Procédé de fabrication d'une cellule test (100) destinée à la qualification d'appareillage de caractérisation de cellules de pile à combustible et/ou de piles à combustible, comportant les étapes consistant à :
- fournir un circuit équivalent (110) passif configuré pour présenter une impédance équivalente à au moins une cellule de pile à combustible, ledit circuit équivalent comportant une première et une deuxième borne de sortie (111, 112),
- fournir une première et une deuxième face de contact (131, 132) comportant chacune couche métallique occupant tout ou partie de la surface de la face contact correspondant et formant respectivement une première et une deuxième une zone de contact (135, 136) et les agencer pour qu'elles délimitent entre elles un volume intérieur dans lequel est logé le circuit équivalent (110) avec sa première et sa deuxième borne de sortie (111, 112) connectées respectivement à la première et à la deuxième zone de contact (135,136).

10. Procédé de fabrication selon la revendication 9, dans lequel l'étape de fourniture de la première et de la deuxième face de contact (131, 132) comporte une sous-étape consistant à :
- encapsuler le circuit équivalent (110) dans un bloc de résine durcissable telle qu'une résine époxyde, polyester insaturé ou époxy acrylate avec la première et la seconde borne (11, 112) du circuit équivalent (110) faisant saillie dudit bloc de résine obtenu après durcissement de ladite résine sur une première et une deuxième face dudit bloc.

11. Procédé de fabrication selon la revendication 10, dans lequel l'étape de fourniture de la première et de la deuxième face de contact (131, 132) comporte en outre les sous-étapes supplémentaires consistant à :
- polir la première et deuxième face du bloc de résine desquelles la première et la deuxième borne (111, 112) du circuit équivalent (110) font saillie,
- déposer la première et la deuxième couche métallique sur la première et la deuxième face du bloc de résine pour former respectivement la première et la deuxième zone de contact (135, 136).

## Patentansprüche

1. Testzelle (100), welche für die Qualifikation einer Vorrichtung zur elektrischen Charakterisierung von Zellen eines Brennstoffzellenstapels und/oder von Brennstoffzellenstapeln vorgesehen ist, wobei die Testzelle (100) **dadurch gekennzeichnet ist, dass** sie umfasst:
- eine erste und eine zweite Kontaktfläche (131, 132), welche jeweils eine erste und eine zweite metallische Schicht umfassen, welche die gesamte oder einen Teil der Oberfläche der entsprechenden Kontaktfläche (131, 132) einnehmen und eine erste bzw. eine zweite Kontaktzone (135, 136) bilden, wobei die erste und die zweite Kontaktfläche (131, 132) zwischen einander ein Innenvolumen begrenzen,
- eine passive Äquivalenzschaltung (110), welche dazu eingerichtet ist, eine Impedanz aufzuweisen, welche zu wenigstens einer Zelle des Brennstoffzellenstapels äquivalent ist, wobei die Äquivalenzschaltung (110) einen ersten und einen zweiten Ausgangsanschluss (111, 112) umfasst, welche mit der ersten bzw. der zweiten Kontaktzone (135, 136) verbunden sind, wobei die Äquivalenzschaltung (110) in dem Innenvolumen aufgenommen ist.

2. Testzelle (100) nach Anspruch 1, wobei der Rest des Innenvolumens mit einem aushärtbaren Harz gefüllt ist, beispielsweise einem Epoxidharz, ungesättigtem Polyester oder Epoxidacrylat.

3. Testzelle (100) nach Anspruch 1 oder 2, wobei die Äquivalenzschaltung (110) in Reihe wenigstens die folgenden Komponenten umfasst:
- eine erste Induktivität (L1),
- einen ersten Widerstand (R1),
- eine oder mehrere Anordnungen (E1, E2, E3, E4, E5), welche jeweils aus einer Kapazität (C1, C2, C3, C4, C5) und einem Widerstand (R2, R3, R4, R5, R6) aufgebaut sind, welche parallel montiert sind.

4. Testzelle (100) nach Anspruch 3, wobei der Induktivitätswert der Induktivität (L1) zwischen 0 und 10 mH beträgt, der Wert von jedem der Widerstände (R1, R2, R3, R4, R5, R6) zwischen 0 und 1 Ohm beträgt und der Wert von jeder der Kapazitäten (C1, C2, C3, C4, C5) zwischen 10 µF und 1 F beträgt.

5. Testzelle (100) nach einem der Ansprüche 1 bis 4, umfassend Komponenten (L1, R1, R2, R3, R4, R5, R6, C1, C2, C3, C4, C5) vom oberflächenmontierten Typ zum Bilden der Äquivalenzschaltung (110).

6. Testzelle (100) nach einem der Ansprüche 1 bis 5, wobei die erste und die zweite Kontaktzone (135, 136) aus einer metallischen Schicht gebildet sind, wobei das Metall aus der Gruppe ausgewählt ist, umfassend Gold und Platin.

7. Testzelle (100) nach einem der Ansprüche 1 bis 6, wobei jede der Kontaktzonen (135, 136) jeweils und im Wesentlichen die Gesamtheit der Oberfläche der entsprechenden Kontaktfläche (131, 132) einnimmt.

8. Testzelle (100) nach einem der Ansprüche 1 bis 7, wobei die Äquivalenzschaltung (110) dazu eingerichtet ist, eine Impedanz aufzuweisen, welche äquivalent zu mehreren Zellen des Brennstoffzellenstapels ist, welche in Reihe vorgesehen sind, und wobei somit ein Test-Brennstoffzellenstapel gebildet ist.

9. Verfahren zum Herstellen einer Testzelle (100), welche für die Qualifikation einer Vorrichtung zur Charakterisierung von Zellen eines Brennstoffzellenstapels und/oder von Brennstoffzellenstapeln vorgesehen ist, umfassend die Schritte bestehend aus:
- Bereitstellen einer passiven Äquivalenzschaltung (110), welche dazu eingerichtet ist, eine Impedanz aufzuweisen, welche äquivalent zu wenigstens einer Zelle des Brennstoffzellenstapels ist, wobei die Äquivalenzschaltung einen ersten und einen zweiten Ausgangsanschluss (111, 112) umfasst,
- Bereitstellen einer ersten und einer zweiten Kontaktfläche (131, 132), welche jeweils eine metallische Schicht umfassen, welche die gesamte oder einen Teil der Oberfläche der Kontaktfläche einnimmt, einer ersten bzw. einer zweiten Kontaktzone (135, 136) entsprechend und sie bildend, und derartiges Anordnen von ihnen, dass sie zwischen einander ein Innenvolumen begrenzen, in welchem die Äquivalenzschaltung (110) mit ihrem ersten und ihrem zweiten Ausgangsanschluss (111, 112) aufgenommen ist, welche mit der ersten bzw. der zweiten Kontaktzone (135, 136) verbunden sind.

10. Verfahren zum Herstellen nach Anspruch 9, wobei der Schritt des Bereitstellens der ersten und der zweiten Kontaktfläche (131, 132) einen Unterschritt umfasst, welcher besteht aus:
- Verkapseln der Äquivalenzschaltung (110) in einem Block aus aushärtbarem Harz, wie beispielsweise einem Epoxidharz, ungesättigtem Polyester oder Epoxidacrylat, wobei der erste und der zweite Anschluss (11, 112) der Äquivalenzschaltung (110) aus dem nach dem Aushärten des Harzes erhaltenen Block an einer ersten und einer zweiten Fläche des Blocks hervorstehen.

11. Verfahren zum Herstellen nach Anspruch 10, wobei der Schritt des Bereitstellens der ersten und der zweiten Kontaktfläche (131, 132) ferner die zusätzlichen Unterschritte umfasst, welche bestehen aus:
- Polieren der ersten und zweiten Fläche des Blocks aus Harz, von welchen der ersten und der zweite Anschluss (111, 112) der Äquivalenzschaltung (110) hervorstehen,
- Anlagern der ersten und der zweiten metallischen Schicht an der ersten und der zweiten Fläche des Blocks aus Harz, um die erste bzw. die zweite Kontaktzone (135, 136) zu bilden.

## Claims

1. A test element (100) for qualifying an apparatus for electrically characterising fuel cell elements and/or fuel cells, said test element (100) being **characterised in that** it includes:
- a first and a second contact face (131, 132) respectively including a first and a second metal layer occupying all or part of the area of the corresponding contact face (131, 132) and respectively forming a first and a second contact zone (135, 136), the first and the second contact faces (131, 132) delimiting an internal volume between them,
- a passive equivalent circuit (110) configured to exhibit an impedance equivalent to at least one fuel cell element, said equivalent circuit (110) including a first and a second output terminal (111, 112) respectively connected to the first and the second contact zones (135, 136), the equivalent circuit (110) being housed in the internal volume.

2. The test element (100) according to claim 1, wherein the rest of the internal volume is filled with a curable resin such as an epoxide resin, unsaturated polyester or epoxy acrylate.

3. The test element (100) according to claim 1 or 2, wherein the equivalent circuit (110) includes at least the following components in series:
- a first inductance (L1),
- a first resistance (R1),
- one or more assemblies (E1, E2, E3, E4, E5) each comprised of a capacitance (C1, C2, C3, C4, C5) and of a resistance (R2, R3, R4, R5, R6) connected in parallel.

4. The test element (100) according to claim 3, wherein the inductance value of the inductance (L1) is between 0 and 10mH, the value of each of the resistances (R2, R3, R4, R5, R6) is between 0 and 1 Ohm and the value of each of the capacitances (C1, C2, C3, C4, C5) is between 10µF and 1F.

5. The test element (100) according to any of claims 1 to 4, including components (L1, R1, R2, R3, R4, R5, R6, C1, C2, C3, C4, C5) of the surface-mounted component type to form the equivalent circuit (110).

6. The test element (100) according to any of claims 1 to 5, wherein the first and the second contact zones (135, 136) are formed by a metal layer the metal of which is selected from the group including gold and platinum.

7. The test element (100) according to any of claims 1 to 6, wherein each of the contact zones (135, 136) respectively occupies substantially the entire area of the corresponding contact face (131, 132).

8. The test element (100) according to any of claims 1 to 7, wherein the equivalent circuit (110) is configured to exhibit an impedance equivalent to several fuel cell elements connected in series and thus forming a test fuel cell.

9. A method for manufacturing a test element (100) for qualifying an apparatus for characterising fuel cell elements and/or fuel cells, including the steps of:
- providing a passive equivalent circuit (110) configured to exhibit an impedance equivalent to at least one fuel cell element, said equivalent circuit including a first and a second output terminal (111, 112),
- providing a first and a second contact face (131, 132) each including a metal layer occupying all or part of the area of the corresponding contact face and respectively forming a first and a second contact zone (135, 136) and arranging them such that they delimit an internal volume between them in which the equivalent circuit (110) is housed with its first and second output terminals (111, 122) respectively connected to the first and second contact zones (135, 136).

10. The manufacturing method according to claim 9, wherein the step of providing the first and the second contact faces (131, 132) includes a substep of:
- encapsulating the equivalent circuit (110) in a curable resin block such as an epoxide resin, unsaturated polyester or epoxy acrylate with the first and the second terminals (11, 112) of the equivalent circuit (110) projecting from said resin block obtained after curing said resin on a first and a second face of said block.

11. The manufacturing method according to claim 10, wherein the step of providing the first and the second contact faces (131, 132) further includes the additional substeps of:
- polishing the first and the second faces of the resin block from which the first and the second terminals (111, 112) of the equivalent circuit (110) project,
- depositing the first and the second metal layers on the first and the second faces of the resin block to form the first and the second contact zones (135, 136) respectively.
